# EUROPEAN PATENT APPLICATION

(11) **EP 4 224 337 A1**
(43) Date of publication of application: **09.08.2023**
(21) Application number: 22000034.3
(22) Date of filing: 08.02.2022
(51) Int. Cl.: G06F 16/338, H03M 7/30

(54) **DICTIONARY COMPRESSION FOR TEXT EDITORS**

(71) Applicant: Bauer, Volker, 4020 Linz (AT)
(72) Inventor: Bauer, Volker, 4020 Linz (AT)

(57) **Abstract**

The following abstract tries to point out how it is possible to save IT-memory in the case of a text and refers to the claim of this AnmNr EP22 000 034.3 . The idea is to leave out endings as they are well known and the remaining begin of the word is unique. For this reason it is suggested to have abbreviation -tables: These tables could be included for any text especially in text-programs and could also be supplied for e-books.

## Description

The following abstract tries to point out how it is possible to save IT-memory in the case of a text and refers to the claim of this AnmNr EP22 000 034.3 . The idea is to leave out endings as they are well known and the remaining begin of the word is unique. For this reason it is suggested to have abbreviation -tables: These tables could be included for any text especially in text-programs and could also be supplied for e-books.

The memory text is then different to the editor text but the user should never see the memory text. When the text is saved the program rushes through the text and exchanges the words also found in the abbreviation table (here word column) by the entry in the abbreviation-column. When a saved text is opened for editing the program also rushes through the text and exchanges the abbreviations also found in the abbreviation-column by the corresponding word entry in the word column. The abbreviation-column can only have entries that are not known words in this language in question.

A software engineer with sufficient knowledge should be able to read the memory text also because the abbreviations in the abbreviation-column in the suggested table should be intuitively clear even stand alone. If there really is a problem then the software-engineer must be able to have a look at the abbreviation-table. This can always be possible because the abbreviation-table is used by the programs in both directions.

In the common memory for IT (ANSI) a letter is saved in 1 byte = 8 bits, this means 0 to 255 as possibilities. In Unicode a sign is saved in 2 bytes = 16 bits, this means 0 to 65535 as possibilities.

With this method a text can be saved in less memory and all other methods to save memory after will not lack percentage after.

Where it is possible the suggestion is also for shorthand : To leave out endings is better than to have short forms.

The languages English, German and French are discussed in considering common endings as a suggestion.

### 1) English

The common endings to be discussed in little tables are: -ght; -ility; -ing; -ion ; -ious; -ment; -ous; -ure.

| | | |
|---|---|---|
| word / editor | | memory |
| fight | | fig |
| light | | lig |
| night | | nig |
| right | | rig |
| sight | | sig |
| slight | | slig |
| ability | | abil |
| possibility | | possibil |
| probability | | probabil |
| word | editor | memory |
| assume | assuming | assum |
| combine | combining | combin |
| conceive | conceiving | conceiv |
| confirm | confirming | confir |
| decrease | decreasing | decreas |
| desert | deserting | deser |
| deserve | deserving | deserv |
| destroy | destroying | destro |
| (dis)claim | (dis)claiming | (dis)clai |
| distinguish | distinguishing | distinguis |
| establish | establishing | establis |
| (ex)change | (ex)changing | (ex)chang |
| extinguish | extinguishing | extinguis |
| find | finding | fin |
| forsake | forsaking | forsak |
| (ful)fill | (ful)filling | (ful)fil |
| gouvern | gouverning | gouver |
| grieve | grieving | griev |
| grow | growing | gro |
| word | editor | memory |
| hike | hiking | hik |
| hire | hiring | hir |
| increase | increasing | increas |
| learn | learning | lear |
| lend | lending | len |
| mean | meaning | mea |
| organize | organizing | organiz |
| preserve | preserving | preserv |
| presume | presuming | presum |
| publish | publishing | publis |
| push | pushing | pus |
| put | putting | pu |
| question | questioning | questio |
| receive | receiving | receiv |
| remain | remaining | remai |
| remember | remembering | remembe |
| remind | reminding | remin |
| rent | renting | ren |
| word | editor | memory |
| repeat | repeating | repea |
| replace | replacing | replac |
| (re)solve | (re)solving | (re)solv |
| respire | respiring | respir |
| restore | restoring | restor |
| retain | retaining | retai |
| reveal | revealing | revea |
| rush | rushing | rus |
| sail | sailing | sai |
| see | seeing | se |
| sew | sewing | not possible |
| shock | shocking | shoc |
| strike | striking | strik |
| suggest | suggest | sugges |
| word/editor | | memory |
| edition | | editi |
| question | | questi |
| superstition | | superstiti |
| suspicion | | suspici |
| version | | versi |
| word/editor | | memory |
| superstitious | | superstitio |
| suspicious | | suspicio |
| department | | departm |
| environment | | environm |
| establishment | | establishm |
| government | | governm |
| predicament | | predicam |
| famous | | famo |
| rigorous | | rigoro |
| figure | | figu |
| gesture | | gestu |
| treasure | | treasu |

### 2) German

The endings to be discussed as an example are -heit; -ig; -ion; -keit; -lich ; -mus; -nis; -ung .

| | |
|---|---|
| word/editor | memory |
| Gelassenheit | Gelassenh |
| Keuschheit | Keuschh |
| Nüchternheit | Nüchternh |
| word/editor | memory |
| Schlichtheit | Schlichth |
| mäßig | mäßi |
| sonnig | sonni |
| verhältnismäßig | verhältnismäßi |
| wolkig | wolki |
| Diktion | Dikti |
| Kommunion | Kommuni |
| Achtsamkeit | Achtsamk |
| Bedeutsamkeit | Bedeutsamk |
| Gebrechlichkeit | Gebrechlichk |
| Übelkeit | Übelk |
| gebrechlich | gebrechl |
| gemütlich | gemütl |
| lächerlich | lächerl |
| wesentlich | wesentl |
| Kommunismus | Kommunism |
| Masochismus | Masochism |
| Sadismus | Sadism |
| Sarkasmus | Sarkasm |
| word/editor | memory |
| Ärgernis | Ärgern |
| Empfängnis | Empfängn |
| Ersparnis | Ersparn |
| Verhältnis | Verhältn |
| Versäumnis | Versäumn |
| Achtung | Achtu |
| Bedeutung | Bedeutu |
| Salbung | Salbu |

The two different endings -ig and -ion are both abbreviated as an -i but there can be no confusion because one are adjectives and the second class of words are nouns. The words are totally different even if big and little letters are mixed or confused in the beginning of the word and the abbreviations are intuitively clear. The -ion words are Latin based nouns and the -ig words are simple adjectives. The argument here is only for the software engineers because the entries in the abbreviation-table are unique anyway.

### 3) French

The endings to be discussed are -age; -aire ; -ant ; -eur; -euse ; -eux; -ible ; -iel; -ielle; -ion; -ique ; isme; - ment; -ogue; -oir; -que; -yer.
- euse is discussed two times, first as an adjective and second as a noun.

| | |
|---|---|
| word/editor | memory |
| nuage | nuag |
| word/editor | memory |
| nucléaire | nucléai |
| penchant | pencha |
| employeur ( -eur not possible because of -eux and -euse ) | employeur |
| épineuse | épineu |
| employeuse | employeu |
| épineux | épine |
| perceptible | perceptib |
| essentiel | essenti |
| essentielle | essentie |
| intention | intenti |
| perfection | perfecti |
| générique | génériq |
| pédagogique | pédagogiq |
| word/editor | memory |
| juristique | juristiq |
| parachutisme | parachutis |
| enregistrement | enregistrem |
| équipement | équipem |
| jugement | jugem |
| pedagogue | pedagog |
| entrevoir | entrevo |
| kiosque | kiosq |
| noyer | noy |

The two different endings -iel and -ion are both abbreviated as an -i but there can be no confusion because one are adjectives and the second class of words are nouns. The abbreviations are intuitively clear for a software engineer with sufficient knowledge of the language. The -ion words are Latin based nouns and the -iel words are simple adjectives. The abbreviation table has unique entries anyway.

The ending -euse occurs both in the case of nouns and in the case of adjectives and is abbreviated as -eu in both cases so there can be no confusion.

## Claims

1. The following claim tries to explain where the limits are to use abbreviations in IT-texts-memory and refers to the abstract with the same AnmNr EP22 000 034.3 .
It must be stressed that this method is suggested and claimed in general for any kind of level of a text, this means the text that leads someone through a program, also the world the user enters with F1-help (for example) as well as what is written or read by the user (text-programs and e-books).
Whenever a word can be identified unique after being abbreviated in ending it is suggested to the abbreviation table of this language. The same is possible if there is a convention in a certain language for abbreviating a word with the most occurrence instead of others that should have the same abbreviation.
The method to have an abbreviation table between any kind of IT-memory (hard-disk, CD, USB-stick...) and the seen, edited or printed text is claimed in general.
The words and their abbreviations could be saved in arbitrary order as an abbreviation table but with unique abbreviations, it is only necessary to have a sql-join to the words and to their abbreviations in alphabetical order for the IT-expert. It is presumed that it turns out that the sql-join is a speed problem then it is best for performance to have two abbreviation tables in alphabetical order in both directions.
Sql-join or database-hardcoded, both methods are possible as long as unique occurrence is guaranteed. The best way is to save word by word and after ending an abbreviation table to save the sql-joins in both directions as a separate table. To add words after a release and therefore enforce the use of an sql-join at runtime is not recommended.
The claim is for any IT-environment not depending on the size of memory, clock frequency or application of the software or IT-object. The claim is for any kind of memory in a binary style. Furthermore if there is an impact on shorthand the method is claimed for teaching shorthand.
Suggestions for abbreviations of a several kinds are presented in the abstract for the languages English, German and French.
The claim is restricted to endings being abbreviated, in languages where there are common endings. But the claim is for all languages where there are common endings.
